# EUROPÄISCHE PATENTSCHRIFT

(11) **EP 0 789 496 B1**
(45) Veröffentlichungstag und Bekanntmachung des Hinweises auf die Patenterteilung: **17.10.2001**
(21) Anmeldenummer: 97200231.5
(22) Anmeldetag: 29.01.1997
(51) Int. Cl.: H04N 9/64, H03H 17/02, H04N 9/79

(54) **Kammfilteranordnung**
Comb filter
Filtre en peigne

(30) Priorität: 10.02.1996 DE 19604929
(43) Veröffentlichungstag der Anmeldung: 13.08.1997
(73) Patentinhaber: Philips Corporate Intellectual Property GmbH, 52064 Aachen (DE); Koninklijke Philips Electronics N.V., 5621 BA Eindhoven (NL)
(72) Erfinder: Struck, Sönke, Röntgenstrasse 24, 22335 Hamburg (DE); Steinfatt, Ole, Röntgenstrasse 24, 22335 Hamburg (DE)
(74) Vertreter: von Laue, Hanns-Ulrich, Dipl.-Ing.

(56) Entgegenhaltungen:
- DE-A- 4 022 923
- DE-A- 19 525 804

## Beschreibung

Die Erfindung betrifft eine Kammfilteranordnung mit einer wenigstens zwei Speicherzellen aufweisenden Verzögerungsanordnung (3) und einer ersten Anpassungsanordnung (1), denen ein der Kammfilteranordnung zugeführtes, eine Folge einzelner Bildpunkte aufweisendes Bildsignal zugeführt wird und deren Ausgangssignale mittels einer Überlagerungsstufe (4) überlagert werden, welche ausgangsseitig ein gefiltertes Bildsignal liefert, wobei die Anpassungsanordnung (1) so ausgelegt ist, daß sie dem ihr zugeführten Bildsignal etwa die gleichen Amplitudenveränderungen zufügt wie die Verzögerungsanordnung (3) und daß die Differenz der Verzögerung der Ausgangssignale der Verzögerungsanordnung (3) und der Anpassungsanordnung (1) einem Sollwert entspricht, wobei eine zweite Anpassungsanordnung (2) und eine Umschaltanordnung (6) vorgesehen sind und wobei der zweiten Anpassungsanordnung (2) eingangsseitig das ungefilterte Bildsignal zugeführt wird.

Derartige Kammfilteranordnungen sind für Anwendungen in Fernsehern oder Videorekordern bekannt. Als Verzögerungsanordnung werden dabei Glasverzögerungsleitungen oder CCD-Zellen (Charged Coupled Devices) eingesetzt. Aus der DE-A-4 022 923 ist eine Schaltungsanordnung bekannt, welche im wiedergabeseitigen Farbsignal-Übertragungskanal eines Videorekorders angeordnet ist. Sie weist ein Kammfilter auf, welches mittels eines Umschalters zeitweise umgangen werden kann, so daß dann zeitweise die Kammfilterwirkung nicht eintritt. Aus dem Dokument DE-A-195 25 804 ist eine Kammfilteranordnung bekannt, welche eine Verzögerungsanordnung aufweist, dessen Ausgangssignal in einem Addierer gewonnen wird, wobei in dem Addierer Signale überlagert werden, die relativ zueinander um eine vorgegebene Dauer verzögert sind.

Für weiter verbesserte Bildqualität bzw. zur noch präziseren Bearbeitung des Bildsgnals besteht vielfach der Wunsch, derartige Kammfilteranordnungen zeitweise, idealerweise pixelweise, ein- bzw. auszuschalten. Die bekannten Kammfilteranordnungen sind dafür jedoch nicht geeignet, da entweder ein Ausschalten der Vezögerungsanordnung aufgrund ihrer Funktionsweise überhaupt nicht möglich ist, oder bei einem Ausschalten der Verzögerungsanordnung sich am Ausgang der Kammfilteranordnung ein Verstärkungsfehler ergibt, da bei ausgeschalteter Verzögerungsanordnung der Überlagerungsstufe nur noch das von der Anpassungsanordnung gelieferte Signal geliefert wird. Damit ergeben sich für diejenigen Signalanteile, die von der Anpassungsanordnung und der Verzögerungsanordnung geliefert werden und die sich normalerweise gleichphasig überlagern, Amplituden- bzw. Verstärkungsfehler.

Es ist Aufgabe der Erfindung, eine Kammfilteranordnung anzugeben, die ein Ein- und Ausschalten der Kammfilterfunktion ohne Verstärkungs- und/oder Phasenfehler ihres Ausgangssignals erlaubt.

Diese Aufgabe ist erfindungsgemäß dadurch gelöst, daß die zweite Anpassungsanordnung (2) dem ausgangsseitigen Bildsignal etwa die gleichen Amplitudenveränderungen und Verzögerungen mittels der Überlagerungsstufe (4) hinzufügt wie die erste Anpassungsanordnung (1) und daß die Umschaltanordnung zum Ein- bzw. Ausschalten der Kammfilterfunktion alternativ die zweite Anpassungsanordnung (2) oder die Verzögerungsanordnung (3) deaktiviert.

Es sind bei der erfindungsgemäßen Kammfilteranordnung zwei Anpassungsanordnungen und eine Verzögerungsanordnung vorgesehen. Für den Betrieb mit Kammfilterfunktion wird der Überlagerungsstufe das Ausgangssignal der ersten Anpassungsanordnung und der Verzögerungsanordnung zugeführt. Dazu schaltet die Umschaltanordnung die zweite Anpassungsanordnung aus und die Verzögerungsanordnung ein. Bei diesem Betrieb ist die normale Kammfilterfunktion gegeben.

Beispielsweise kann die Verzögerungsanordnung das ihr zugeführte Eingangssignal etwa um die Dauer zweier Bildzeilen verzögern, so daß in der Überlagerungsstufe dieser zugeführten Signale etwa um eine Zeitdifferenz zweier Bildzeilen verzögert überlagert werden. Da Verzögerungsanordnungen im allgemeinen aus technischen Gründen nicht so aufgebaut werden können, daß sie eine exakte Zeitverzögerung um die gewünschte Dauer, beispielsweise die Dauer zweier Bildzeilen, vornehmen, ist die Anpassungsanordnung vorgesehen. Die Anpassungsanordnung weist dazu eine solche Zeitverzögerung auf, daß die zeitliche Differenz der Ausgangssignale der Anpassungsanordnung und der Verzögerungsanordnung relativ zueinander die gewünschte Zeitverzögerung aufweisen. Ferner ist die Anpassungsanordnung so ausgelegt, daß sie dem ihr zugeführten Signal die gleichen Amplitudenfehler zufügt, wie dies gegebenenfalls die Verzögerungsanordnung mit dem ihr zugeführten Signal tut.

Bei der erfindungsgemäßen Kammfilteranordnung besteht über diesen Betrieb hinaus die Möglichkeit, die Kammfilterfunktion zeitweise auszuschalten. Dazu deaktiviert die Umschaltanordnung die Verzögerungsanordnung und aktiviert statt dessen die zweite Anpassungsanordnung. Dies hat zur Folge, daß in der Überlagerungsstufe die beiden Ausgangssignale der ersten und der zweiten Anpassungsanordnung überlagert werden. Es handelt sich dabei um nicht bzw. um den gleichen Wert verzögerte Signale, so daß die Kammfilterfunktion entfällt. Dadurch, daß der Überlagerungsstufe diese beiden gleichphasigen Signale zugeführt werden, treten jedoch keine Amplituden- bzw. Verstärkungsfehler auf. Wie bei eingeschalteter Kammfilterfunktion überlagern sich gleichphasige Signale in der Überlagerungsstufe gleichphasig, so daß beim Umschaltvorgang keine Verstärkungsänderung bzw. Amplitudenänderung des Ausgangssignals der Überlagerungsstufe für diese Signale stattfindet. Es ist damit die Möglichkeit gegeben, die Kammfilterfunktion jederzeit, ggf. auch innerhalb einer Bildzeile des Fernsehsignals umzuschalten. Darüber hinaus arbeitet die erfindungsgemäße Kammfilteranordnung abgleichfrei.

Das bildpunktweise Ein- bzw. Ausschalten der Kammfilterfunktion kann vorteilhafterweise gemäß weiteren Ausgestaltungen der Erfindung in der Weise vorgenommen werden, daß die Umschaltanordnung eine Deaktivierung der Verzögerungsanordnung bzw. der Anpassungsanordnung in der Weise vornimmt, daß deren Speicherzellen einzeln deaktiviert werden, so daß eine bildpunktgenaue Ein- bzw. Ausschaltung der Kammfilterfunktion vorgenommen wird.

Die Umschaltanordnung aktiviert bzw. deaktiviert also alternativ entweder die Speicherzellen der Verzögerungsanordnung oder der zweiten Anpassungsanordnung. Somit kann bildpunktgenau die Kammfilterfunktion ein- bzw. ausgeschaltet werden.

Gemäß einer weiteren Ausgestaltung der Erfindung ist vorgesehen, daß die Verzögerungsanordnung und die zweite Anpassungsanordnung jeweils Speicherzellen mit je einem kapazitiven Speicherelement, mit einem Schreibtransistor, mittels dessen Daten des Bildsignals aus einer Schreibleitung in das kapazitive Speicherelement einschreibbar ist, und je einem Lesetransistor aufweisen, mittels dessen aus dem kapazitiven Speicherelement eine Information auf eine Leseleitung auslesbar ist, wobei die Transistoren mittels je eines Steuersignals geschaltet werden, wobei die Umschaltanordnung zur individuellen Deaktivierung der Funktion einzelner Speicherzellen die den Lesetransistoren der zu deaktivierenden Speicherzellen zugeführten Steuersignale unterbricht.

Die Verzögerungsanordnungen und die Anpassungsanordnungen können vorteilhaft aus Speicherzellen aufgebaut sein, die je ein kapazitives Speicherelement aufweisen, in dem die Information gespeichert wird. Der Einschreibvorgang wird über eine Schreibleitung vorgenommen, deren Information über einen Schreibtransistor in das kapazitive Element eingelesen wird. Der Auslesevorgang wird gesteuert mittels eines Lesetransistors auf eine Leseleitung vorgenommen. Die Schreib- bzw. Lesetransistoren werden mittels Steuersignale geschaltet, wobei bei benachbarten Speicherzellen vorzugsweise das Steuersignal der Speicherzelle n für deren Lesetransistor identisch ist mit dem Steuersignal des Schreibtransistors der Speicherzelle n+1.

Für derartig aufgebaute Speicherzellen der Verzögerungsanordnung und/oder beider Anpassungsanordnungen kann eine Ein- bzw. Ausschaltung der Funktion der Kammfilteranordnung dadurch vorgenommen werden, daß die Steuersignale für die Lesetransistoren in der zu deaktivierenden Anordnung unterbrochen werden. Damit kann pixelweise, d.h. bildpunktgenau, eine Ein- bzw. Ausschaltung der ersten Verzögerungsanordnung und der zweiten Anpassungsanordnung vorgenommen werden, so daß die Kammfilterfunktion ebenfalls pixelgenau umgeschaltet werden kann.

Wie nach einer weiteren Ausgestaltung der Erfindung vorgesehen ist, kann die Unterbrechung der Steuersignale für die Lesetransistoren vorteilhaft mittels Transistoren vorgenommen werden.

Nachfolgend wird ein Ausführungsbeispiel der Erfindung anhand der Zeichnung näher erläuert. Es zeigen:
Fig. 1 ein Blockschaltbild einer Ausführungsform der erfindungsgemäßen Kammfilteranordnung und
Fig. 2 ein Schaltbild einer Speicherzelle der Verzögerungsanordnung und/oder der zweiten Anpassungsanordnung der Schaltungsanordnung gemäß Fig. 1.

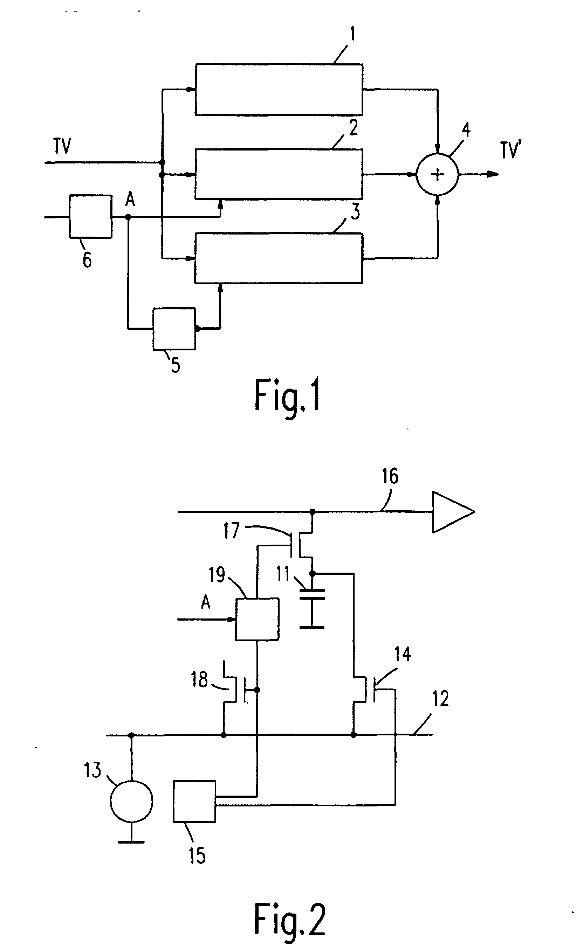

Die Kammfilteranordnung gemäß Fig. 1 weist eine erste Anpassungsanordnung 1, eine zweite Anpassungsanordnung 2 sowie eine Verzögerungsanordnung 3 auf. Diesen drei Anordnungen wird ein der Kammfilteranordnung eingangsseitig zugeführtes Bildsignal TV zugeführt.

Die Ausgänge der Anordnungen 1, 2 und 3 sind auf eine Überlagerungsstufe 4 geführt, in der die dieser zugeführten Signale additiv überlagert werden.

Um eine Kammfilterwirkung zu erzielen, kann beispielsweise die Verzögerungsanordnung 3 für Einsatzzwecke in Videorekordern eine Verzögerung um etwa zwei Bildzeilen des Fernsehsignals TV erzeugen. Aufgrund des Aufbaues einer solchen Verzögerungsanordnung verzögert diese das ihr zugeführte Signal ggf. nicht exakt um die Dauer zweier Bildzeilen. Ferner kann sie dem ihr zugeführten Signal Amplitudenfehler zufügen.

Zur Kompensation dieser Effekte sind die erste Anpassungsanordnung 1 und die zweite Anpassungsanordnung 2 so ausgelegt, daß sie dem ihnen zugeführten Signal die gleichen Amplitudenfehler zufügen wie die Verzögerungsanordnung 3. Darüber hinaus können die beiden Anpassungsanordnungen 1 bzw. 2 dem Signal solche Zeitverzögerungen zufügen, daß die Ausgangssignale der Anpassungsanordnungen 1 bzw. 2 einerseits und das Ausgangssignal der Verzögerungsanordnung 3 andererseits in der Überlagerungsstufe 4 mit einer gewünschten relativen zeitlichen Verzögerung überlagert werden. Weist beispielsweise die Verzögerungsanordnung 3 statt der gewünschten Verzögerung um die Dauer genau zweier Bildzeilen eine Verzögerung auf, die etwas größer ist, so können die Anpassungsanordnungen 1 bzw. 2 so ausgelegt werden, daß sie ebenfalls eine geringere Verzögerung der ihnen zugeführten Signale bewirken, so daß die Überlagerung in der Überlagerungsstufe 4 wieder mit einer Zeitdifferenz entsprechend der Dauer genau zweier Bildzeilen erfolgt.

Eine ferner vorgesehene Umschaltanordnung 6 erzeugt ein Signal A, welches der zweiten Anpassungsanordnung 2 zugeführt wird. Das Signal A wird mittels eines Inverters 5 invertiert. Das invertierte Signal A gelangt an die Verzögerungsanordnung 3.

Für normalen Kammfilterbetrieb ist mittels des Signales A die zweite Anpassungsanordnung 2 deaktiviert, die Verzögerungsanordnung 3 hingegen aktiviert. Damit gelangen auf die Überlagerungsstufe die Ausgangssignale der ersten Anpassungsanordnung 1 sowie der Verzögerungsanordnung 3. Es ist somit die normale Kammfilterfunktion gegeben und die Anordnung liefert ausgangsseitig ein kammgefiltertes Fernsehsignal TV'.

Wird das Signal A deaktiviert, so wird die zweite Anpassungsanordnung 2 aktiviert und die Verzögerungsanordnung 3 deaktiviert. Damit überlagern sich in der Überlagerungsstufe 4 die gleichphasigen Signale der beiden Anpassungsanordnungen 1 und 2. Während dieser Zeitspannen ist das Ausgangssignal TV' nicht kammgefiltert und entspricht abgesehen von eventuell auftretenden Amplitudenfehlern und einer gegebenenfalls in den Anpassungsanordnungen 1 und 2 erzeugten geringen Zeitverzögerung dem Eingangssignal TV.

Die Anpassungsanordnungen 1 und 2 und die Verzögerungsanordnung 3 der Schaltungsanordnung gemäß Fig. 1 können vorteilhafterweise Speicherzellen aufweisen, von denen in Fig. 2 exemplarisch eine Speicherzelle dargestellt ist. Die in Fig. 2 dargestellte Speicherzelle weist ein kapazitives Speicherelement 11 auf. Es ist eine Schreibleitung 12 vorgesehen, auf die beispielsweise von einer Signalquelle 13 Signale gegeben werden können. Ein auf die Schreibleitung 12 gegebenes Signal kann über einen Schreibtransistor 14 auf das kapazitive Speicherelement 11 gegeben werden. Dazu wird der Schreibtransistor 14 mittels eines Steuersignals angesteuert, welches mittels einer Anordnung 15 zur Generation von Steuersignalen erzeugt wird. Während des normalen Betriebes der Speicherzelle, also wenn deren Informationen, die in dem kapazitiven Speicherelement 11 gespeichert sind, auf eine Ausleseleitung 16 ausgegeben werden sollen, wird, gesteuert durch ein Steuersignal der Auslesesleitung 16 ein Lesetransistor 17 aktiviert, über den die in dem kapazitiven Speicherelement 11 gespeicherten Informationen auf die Ausleseleitung 16 ausgelesen werden.

In einer Anpassungsanordnung bzw. Verzögerungsanordnung sind mehrere solcher Speicherzellen nebeneinander angeordnet, wobei die Ausleseleitung 16 und die Einleseleitung 12 im allgemeinen ebenfalls für eine Gruppe derartiger Speicherzellen gemeinsam vorgesehen sind.

Dabei sind die Steuersignale für einen Lesetransistor einer Speicherzelle n und eines Schreibtransistors einer Speicherzelle n+1 im allgemeinen identisch. Dies ist in der Fig. 2 durch einen Schreibtransistor 18 angedeutet, der zu einer in der Fig. 2 nicht näher dargestellten Speicherzelle, die der in Fig. 2 dargestellten Speicherzelle benachbart wäre, gehören würde.

Zur bildpunktgenauen Aktivierung bzw. Deaktivierung der Kammfilterfunktion der Anordnung gemäß Fig. 1 müssen in der zweiten Anpassungsanordnung 2 und der Verzögerungsanordnung 3 vorgesehene Speicherzellen, die beispielsweise entsprechend der Anordnung gemäß Fig. 2 aufgebaut sein können, einzeln aktiviert bzw. deaktiviert werden. Dazu ist in der Speicherzelle gemäß Fig. 2 ein Schaltelement 19 vorgesehen, dem von außen ein Schaltsignal A zugeführt wird. Ist die Speicherzelle der Darstellung gemäß Fig. 2 aktiviert, so läßt das Schaltelement 19, gesteuert durch das Signal A, das von der Anordnung 15 gelieferte Schaltsignal passieren, so daß es an den Lesetransistor 17 gelangt und diesen in gewünschter Weise steuert. Damit liefert die Speicherzelle ein Ausgangssignal, d.h. bei aktiviertem Steuersignal gelangt die Information aus der kapazitiven Speicherzelle 11 auf die Ausleseleitung 16.

Zur Deaktivierung der Speicherzelle gemäß Fig. 2 wird bei aktiviertem Signal A das von der Anordnung 15 gelieferte Steuersignal gesperrt, so daß es nicht mehr an den Lesetransistor 17 gelangt. Damit gelangt auch die in dem kapazitiven Speicherelement 11 gespeicherte Information nicht mehr über den Lesetransistor 17 auf die Ausleseleitung 16. Die Speicherzelle liefert kein Ausgangssignal.

Die zweite Anpassungsanordnung 2 und die Verzögerungsanordnung 3 können gegebenenfalls in ähnlicher Weise aus Speicherzellen entsprechend Fig. 2 aufgebaut sein. Der Unterschied beider Anordnungen besteht dann darin, daß in der Verzögerungsanordnung das Auslesen der Information aus dem kapazitiven Element entsprechend der gewünschten Verzögerung stattfindet, wohingegen bei der zweiten Anpassungsanordnung ein Auslesen quasi unmittelbar nach dem Einlesevorgang stattfindet.

Die jeweils gleichen Bildpunkten zugeordneten Speicherzellen in der zweiten Anpassungsanordnung 2 und der Verzögerungsanordnung 3 werden entgegengesetzt geschaltet, d.h. beispielsweise einem bestimmten Bildpunkt zugeordnete Speicherzellen in beiden Anordnungen werden so geschaltet, daß entweder die zugeordnete Speicherzelle in der zweiten Anpassungsanordnung 2 aktiviert und in der Verzögerungsanordnung 3 deaktiviert oder in der zweiten Anpassungsanordnung 2 deaktiviert und in der Verzögerungsanordnung 3 aktiviert sind. Diese bildpunktgenaue Umschaltung kann mittels des Schaltsignals A erzeugt werden, so daß die Speicherzellen einzeln ein- bzw. ausgeschaltet werden können.

Für die Anordnung gemäß Fig. 1 ergibt sich damit der Vorteil, daß für die in der Überlagerungsstufe 4 überlagerten Signale bildpunktgenau eine Aktivierung bzw. Deaktivierung der Kammfilterfunktion vorgenommen werden kann.

Eine Deaktivierung der Kammfilterfunktion kann beispielsweise an vertikalen Flanken des Bildsignals wünschenswert sein, da bei aktivierter Kammfilterfunktion dort im allgemeinen eine Verschleifung eintritt. Durch die präzise Deaktivierung der Kammfilterfunktion kann in solchen Bereichen ein schärferer Bildeindruck erzeugt werden.

## Patentansprüche

1. Kammfilteranordnung mit einer wenigstens zwei Speicherzellen aufweisenden Verzögerungsanordnung (3) und einer ersten Anpassungsanordnung (1), denen ein der Kammfilteranordnung zugeführtes, eine Folge einzelner Bildpunkte aufweisendes Bildsignal zugeführt wird und deren Ausgangssignale mittels einer Überlagerungsstufe (4) überlagert werden, welche ausgangsseitig ein gefiltertes Bildsignal liefert, wobei die Anpassungsanordnung (1) so ausgelegt ist, daß sie dem ihr zugeführten Bildsignal etwa die gleichen Amplitudenveränderungen zufügt wie die Verzögerungsanordnung (3) und daß die Differenz der Verzögerung der Ausgangssignale der Verzögerungsanordnung (3) und der Anpassungsanordnung (1) einem Sollwert entspricht, wobei eine zweite Anpassungsanordnung (2) und eine Umschaltanordnung (6) vorgesehen sind und wobei der zweiten Anpassungsanordnung (2) eingangsseitig das ungefilterte Bildsignal zugeführt wird,
**dadurch gekennzeichnet,**
**daß** die zweite Anpassungsanordnung (2) dem ausgangsseitigen Bildsignal etwa die gleichen Amplitudenveränderungen und Verzögerungen mittels der Überlagerungsstufe (4) hinzufügt wie die erste Anpassungsanordnung (1) und daß die Umschaltanordnung zum Ein- bzw. Ausschalten der Kammfilterfunktion alternativ die zweite Anpassungsanordnung (2) oder die Verzögerungsanordnung (3) deaktiviert.

2. Kammfilteranordnung nach Anspruch 1, **dadurch gekennzeichnet, daß** die Umschaltanordnung (6) eine gegebenenfalls vorzunehmende Deaktivierung der Verzögerungsanordnung (3) in der Weise vornimmt, daß deren Speicherzellen einzeln deaktiviert werden, so daß eine bildpunktgenaue Ein- bzw. Ausschaltung der Kammfilterfunktion vorgenommen wird.

3. Kammfilteranordnung nach Anspruch 1 oder 2, **dadurch gekennzeichnet, daß** die zweite Anpassungsanordnung (2) wenigstens zwei Speicherzellen aufweist und daß die Umschaltanordnung (6) eine gegebenenfalls vorzunehmende Deaktivierung der zweiten Anpassungsanordnung (2) in der Weise vornimmt, daß deren Speicherzellen einzeln deaktiviert werden, so daß eine bildpunktgenaue Ein- bzw. Ausschaltung der Kammfilterfunktion vorgenommen wird.

4. Kammfilteranordnung nach Anspruch 2 und 3, in der die Verzögerungsanordnung (3) und die zweite Anpassungsanordnung (2) jeweils Speicherzellen mit je einem kapazitiven Speicherelement (11), mit einem Schreibtransistor (14), mittels dessen Daten des Bildsignals aus einer Schreibleitung (12) in das kapazitive Speicherelement (11) einschreibbar ist, und mit je einem Lesetransistor (17) aufweisen, mittels dessen aus dem kapazitiven Speicherelement (11) eine Information auf eine Leseleitung (16) auslesbar ist, wobei die Transistoren (14, 17) mittels je eines Steuersignals geschaltet werden, **dadurch gekennzeichnet, daß** die Umschaltanordnung (6) zur individuellen Deaktivierung der Funktion einzelner Speicherzellen die den Lesetransistoren (17) der zu deaktivierenden Speicherzellen zugeführten Steuersignale unterbricht.

5. Kammfilteranordnung nach Anspruch 4, **dadurch gekennzeichnet, daß** die Unterbrechung der Steuersignale mittels je eines jeder Speicherzelle zugeordneten Transistors vorgenommen wird.

6. Fernsehgerät mit einer Kammfilteranordnung nach einem der Ansprüche 1 bis 5.

7. Videorekorder mit einer Kammfilteranordnung nach einem der Ansprüche 1 bis 5.

## Claims

1. A comb filter arrangement comprising a delay circuit (3) and a first matching circuit (1) having at least two storage cells, which circuits receive a picture signal comprising a sequence of individual pixels applied to the comb filter arrangement and whose output signals are superposed by means of a superposition stage (4) supplying a filtered picture signal from its output, the matching circuit (1) being implemented in such a way that it gives the picture signal applied thereto substantially the same amplitude variations as the delay circuit (3), and that the difference between the delay of the output signals from the delay circuit (3) and those from the matching circuit (1) corresponds to a nominal value, while a second matching circuit (2) and a switching circuit (6) are provided, and the unfiltered picture signal is applied to the input of the second matching circuit (2), **characterized in that** the second matching circuit (2) gives the picture signal at the output substantially the same amplitude variations and delays by means of the superposition stage (4) as the first matching circuit (1), and **in that** the switching circuit for switching the comb filter function on and off alternately deactivates either the second matching circuit (2) or the delay circuit (3).

2. A comb filter arrangement as claimed in claim 1, **characterized in that** the switching circuit (6) performs a possible deactivation of the delay circuit (3) in such a way that its storage cells are individually deactivated, so that the comb filter function is switched on and off with pixel precision.

3. A comb filter arrangement as claimed in claim 1 or 2, **characterized in that** the second matching circuit (2) comprises at least two storage cells, and **in that** the switching circuit (6) performs a possible deactivation of the second matching circuit (2) in such a way that its storage cells are individually deactivated, so that the comb filter function is switched on and off with pixel precision.

4. A comb filter arrangement as claimed in claims 2 and 3, in which the delay circuit (3) and the second matching circuit (2) comprise storage cells each having a capacitive storage element (11), a write transistor (14) by means of which picture signal data can be written into the capacitive storage element (11) via a write line (12), and a read transistor (17) by means of which information can be read from the capacitive storage element (11) via a read line (16), each transistor (14, 17) being switched by means of a control signal, **characterized in that**, for individually deactivating the function of individual storage cells, the switching circuit (6) interrupts the control signals applied to the read transistors (17) of the storage cells to be deactivated.

5. A comb filter arrangement as claimed in claim 4, **characterized in that** the control signals are interrupted by means of transistors each associated with a storage cell.

6. A television apparatus including a comb filter arrangement as claimed in any one of claims 1 to 5.

7. A video recorder including a comb filter arrangement as claimed in any one of claims 1 to 5.

## Revendications

1. Filtre en peigne avec un dispositif retardateur (3) présentant au moins deux cellules de mémoire et un premier dispositif adaptateur (1) auquel est amené un signal d'image présentant une séquence de points d'image individuels et amené au filtre en peigne et dont les signaux de sortie sont superposés à l'aide d'un étage de superposition (4) qui délivre côté sortie un signal d'image filtré, le dispositif adaptateur étant conçu de telle sorte qu'il ajoute au signal d'image qui lui est amené à peu près les mêmes variations d'amplitude que le dispositif retardateur (3) et que la différence du retard des signaux de sortie du dispositif retardateur (3) et du dispositif adaptateur (1) correspond à une valeur de consigne, un deuxième dispositif adaptateur (2) et un dispositif de commutation (6) étant prévus et le signal d'image non filtré étant amené côté entrée au deuxième dispositif adaptateur (2)
**caractérisé en ce**
**que** le deuxième dispositif adaptateur (2) ajoute au signal d'image côté sortie à peu près les mêmes variations d'amplitude et retards à l'aide de l'étage de superposition (4) que le premier dispositif adaptateur (1) et que le dispositif de commutation en vue de la mise sous ou hors tension de la fonction du filtre en peigne désactivant en alternance le deuxième dispositif adaptateur (2) ou le dispositif retardateur (3).

2. Filtre en peigne selon la revendication 1, **caractérisé en ce**
**que** le dispositif de commutation (6) procède à une désactivation à effectuer éventuellement du dispositif retardateur (3) de telle manière que ses cellules de mémoire sont désactivées individuellement afin qu'une mise sous ou hors tension de la fonction du filtre en peigne de la précision du point d'image soit assurée.

3. Filtre en peigne selon l'une des revendications 1 ou 2, **caractérisé en ce**
**que** le deuxième dispositif adaptateur (2) présente au moins deux cellules de mémoire et que le dispositif de commutation (6) procède à une désactivation à effectuer éventuellement du deuxième dispositif adaptateur (2) de telle manière que ses cellules de mémoire sont désactivées individuellement afin qu'une mise sous ou hors tension de la fonction de filtre en peigne soit effectuée avec la précision du point d'image.

4. Filtre en peigne selon l'une des revendications 2 ou 3, dans lequel le dispositif retardateur (3) et le deuxième dispositif adaptateur (2) présentent respectivement des cellules de mémoire avec chacun un élément de mémoire (11) capacitif, avec un transistor d'écriture (14) à l'aide duquel les données du signal d'image d'une ligne d'écriture (12) peuvent être enregistrées dans l'élément de mémoire (11) capacitif et avec chacun un transistor de lecture (17) à l'aide duquel une information de l'élément de mémoire (11) capacitif peut être lue sur une ligne de lecture (16), les transistors (14, 17) étant respectivement montés à l'aide d'un signal de commande, **caractérisé en ce que** le dispositif de commutation (6) en vue de la désactivation individuelle de la fonction de différentes cellules de mémoire interrompt les signaux de commande amenés aux cellules de mémoire à désactiver.

5. Filtre en peigne selon la revendication 4, **caractérisé en ce**
**que** l'interruption des signaux de commande est effectuée à l'aide d'un transistor respectivement affecté à chaque cellule de mémoire.

6. Téléviseur avec un filtre en peigne selon l'une des revendications 1 à 5.

7. Magnétoscope avec un filtre en peigne selon l'une des revendications 1 à 5.
